Europäisches Patentamt

(19) European Patent Office

Office européen des brevets

(11) Publication number: **0 288 802 B1**

(12) EUROPEAN PATENT SPECIFICATION

(45) Date of publication of patent specification: **08.07.92**    (51) Int. Cl.⁵: **H01L 21/90,** H01L 23/52

(21) Application number: **88105611.3**

(22) Date of filing: **08.04.88**

(54) **A multi-level integrated circuit wiring structure from a single metal deposit.**

(30) Priority: **29.04.87 US 43714**

(43) Date of publication of application:
**02.11.88 Bulletin 88/44**

(45) Publication of the grant of the patent:
**08.07.92 Bulletin 92/28**

(84) Designated Contracting States:
**DE FR GB**

(56) References cited:
**US-A- 4 541 893**

(73) Proprietor: **International Business Machines Corporation**
**Old Orchard Road**
**Armonk, N.Y. 10504(US)**

(72) Inventor: **Cronin, John Edward**
**RFD no 3, Sunset Circle Drive**
**Milton Vermont 05468(US)**
Inventor: **Lee, Pei-ing Paul**
**32 Stirrup Circle**
**Williston Vermont 05495(US)**

(74) Representative: **Klocke, Peter, Dipl.-Ing.**
**IBM Deutschland GmbH Patentwesen und**
**Urheberrecht Schönaicher Strasse 220**
**W-7030 Böblingen(DE)**

## Description

The present invention relates to a multi-level integrated circuit wiring structure formed from a single metal deposit.

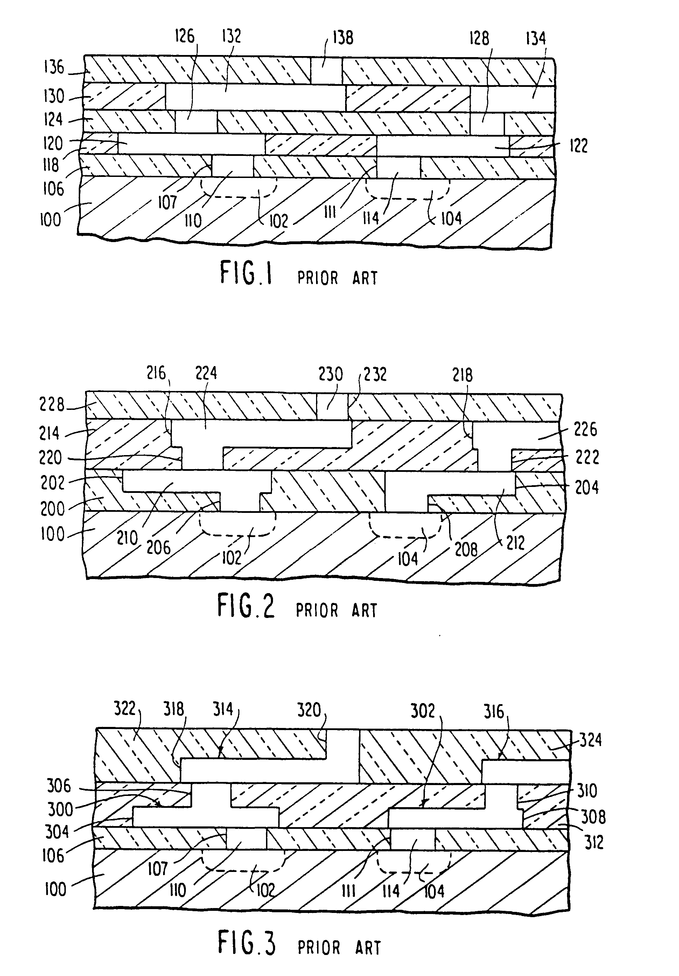

Once a semiconductor substrate has been processed to form the desired circuits, the device must then be provided with a wiring structure. A term which is synonymous with "wiring structure" is that of "metallization structure". A first prior art method which utilizes a layer-by-layer construction approach to provide a wiring structure is shown in Fig. 1.

In detailing the first steps in this approach, a semiconductor substrate 100 is processed to provide semiconductor circuits 102 and 104, and then an insulating layer 106 is formed on top of the semiconductor substrate 100. Next, the insulating layer 106 is masked and etched to provide wiring trenches 107 and 111. These wiring trenches 107 and 111 are etched completely through the insulating layer 106 at locations which correspond to the locations of the semiconductor circuits 102 and 104, respectively. The wiring trenches 107 and 111 are then filled with a conductive material 110 and 114.

Once the wiring trenches 107 and 111 have been filled with the conductive material, the surface of the insulating layer 106 is planarized. The remaining construction of the desired wiring structure proceeds with the formation of successive insulating layers 118, 124, 130 and 136, each of which is masked and etched to form wiring trenches which are then filled with a conductive material.

In the example illustrated in Fig. 1, two resulting wiring structures are shown. The first, consisting of the conductive material deposits 110, 120, 126, 132 and 138, provides connection to the semiconductor circuit 102, and the second, consisting of the conductive material deposits 114, 122, 128 and 134, provides connection to the semiconductor circuit 104.

The above approach to constructing a multi-level wiring structure is well known in the art, for example US-A-3,838,442 (Humphreys), the teaching of which is incorporated herein by reference.

The multiple layer approach shown in the example of Fig. 1 is disadvantageous in several respects. First, an excessive number of masking and deposition steps are required at the end-of-the-line processing stage, whereby manufacturing yield may be lowered. Next, and more importantly, in the resulting wiring structure of Fig. 1, a number of metallic interfaces are formed within the wiring structure. These interfaces add to the overall wiring structure resistance. Furthermore, these localized high resistance areas are prone to overheating and thermal failure.

As a result of the trend of the semiconductor industry toward extremely dense semiconductor circuits, the contact resistance of wiring structures has become a large concern. In this regard, the excessive contact resistances encountered in the prior art approach of Fig. 1 have been found intolerable.

A second prior art approach, which reduces wiring structure metallic interfaces and the number of processing steps, is that of the stud-down approach shown in Fig. 2. In Fig. 2, features which are the same as those in Fig. 1 have been designated by the same reference numerals.

In Fig. 2, the semiconductor substrate 100 has been processed to form the semiconductor circuits 102 and 104. In detailing the processing steps to form the wiring structure, an insulating layer 200 is formed on top of the semiconductor substrate 100. The insulating layer 200 is masked with a first mask, and then partially etched to form wiring troughs 202 and 204. A second mask is then applied, and the insulating layer 200 is further etched to form stud-down vias 206 and 208 which extend down from the bottom portion of the wiring troughs 202 and 204, respectively.

Methods of forming stud-down via wiring structures are well known in the art. As an example, US-A-3,904,454 issued to Magdo et al., discloses a method of forming a stud-down via using a first mask to define a slot in a first direction, and then using a second mask to define and etch an intersecting slot in an intersecting direction. The stud-down via is formed at the intersection of the two etched slots. Another disclosure of the stud-down via approach is found in US-A-4,541,893 issued to Knight.

Once formed, the wiring troughs 202 and 204 and the stud-down vias 206 and 208 are filled with a conductive material. The entire surface of the insulating layer 200 is then planarized.

To form the next portion of the desired wiring structure, the wiring troughs 216 and 218 and their corresponding stud-down vias 220 and 222 are etched in an insulating layer 214. Once etched, the wiring troughs 216 and 218 and the stud-down vias 220 and 222 are filled with conductive materials 224 and 226, respectively. The wiring structure is completed by forming trench 232 in an insulating layer 228, and filling the trench with a conductive material 230.

In comparing the wiring structures of Figs. 1 and 2, note that the two conductive material deposits of Fig. 2 have replaced the four conductive material deposits of Fig. 1. Thus, the stud-down approach of Fig. 2 is advantageous over the approach of Fig. 1 in that the number of metallic interfaces has been reduced by 50%, and the number of processing steps in the resultant wiring structure has also been reduced.

Another prior art approach, which is very similar to the stud-down approach of Fig. 2, is that of the stud-up approach. This approach will be described with reference to Fig. 3. In Fig. 3, elements which are the same as those in Fig. 1 have been given the same reference numerals.

To form the desired wiring structure, vias 107 and 111 are formed in an insulating layer 106 and filled, as was described for Fig. 1. A conductive material (i.e., typically metal) layer is then formed on top of the insulating layer 106 and etched to provide the wiring members 300 and 302. More particularly, the conductive layer is etched such that the wiring member 300 consists of a stud-up 306 and an interconnect 304 formed from the same conductive layer. Similarly, the wiring member 302 consists of a stud-up 310 and an interconnect 308 formed from the same conductive layer.

Once the wiring members 300 and 302 have been formed, an insulating layer 312 is formed and typically planarized to be level with the top of the stud-up structures 306 and 310. Another layer of conductive material (i.e., typically metal) is then formed and processed in a similar manner to form the wiring members 314 and 316. The wiring member 314 comprises a stud-up 320 and an interconnect 318 formed of the same conductive layer. Once the wiring structures 314 and 316 have been formed, an insulating layer 324 is formed and typically planarized to be level with the top of the stud-up structure 320. One reference disclosing methods of constructing stud-up structures is the previously cited US-A-4,541,893.

Like the prior art stud-down approach, the stud-up approach of Fig. 3 is advantageous over the prior art approach of Fig. 1 in that the number of processing steps and metallic interfaces in the wiring structure has been reduced.

Although the stud-down approach of Fig. 2 and stud-up approach of Fig. 3 are both advantageous in the above regards, several contact resistances remain throughout the resultant wiring structures. For example, the interfaces between the conductive materials 230 and 224, 224 and 210, 226 and 212 of Fig. 2 all contribute to an increase in contact resistance. Similarly, the interfaces between the wiring members 314 and 300, 300 and 110, 316 and 302, and 302 and 114 also increase contact resistance.

Although the stud-down and stud-up approaches of Figs. 2 and 3 represent an improvement, these contact resistances have been found intolerable in the construction and operation of highly dense and compact integrated circuits. Thus, there exists a need for an approach which produces wiring structures having little or no internal contact resistances.

In addition to the contact resistance problem, the prior art has also been deficient in providing a versatile construction method whereby wiring structures having thick lines and thin lines can be constructed. Thick line wiring structures are important where low sheet resistance is required, and thin wiring line structures are important where low capacitance lines are needed. Consequently, a need also exists for a wiring structure approach which also has the versatility of allowing both thick and thin line wiring structures to be constructed.

The invention as claimed provides a unique wiring structure and processing approach to satisfy the aforementioned needs.

First, since the invention facilitates the construction of a multi-level wiring structure from a single layer of conductive material, internal metallic interfaces are eliminated. The invention also provides versatility in facilitating the construction of stud-down, stud-up, and thick and thin wiring line structures from the same conductive material layer. The result is the ability to construct multi-level wiring structures which have external connection structures represented by stud-up and stud-down structures, and low resistance and low capacitance lines represented by thick and thin wiring line structures respectively. Finally, the present invention is advantageous in decreasing the number of wiring structure processing steps compared with that of the prior art.

Accordingly, the present invention relates to a wiring (metallization) structure being a homogeneous conductive material structure on an insulation layer on a processed semiconductor substrate, comprising: at least one stud-down; a plurality of wiring (interconnection) lines, at least one of said plurality of wiring (interconnection) lines having a first thickness and at least another one of said plurality of wiring (interconnection) lines having a second thickness greater than said first thickness; and at least one stud-up, said wiring lines being aligned with and electrically connecting said stud-ups or stud-downs, at least one wiring line electrically connecting at least one of said stud-ups and at least one of said stud downs, the metallization structure thus providing an electrical conduction path, from at least one of said stud-downs to at least one of said stud-ups, which has no internal metallic interface, said stud-down, said plurality of wiring (interconnection) lines and said stud-up being formed from a single layer of metal.

According to another aspect, the invention relates to a method of forming, a wiring (metallization) structure according to one of the claims 2 to 4 making possible thick wiring line structures representing low resistance lines, and thin wiring line structures representing low capacitance lines.

As a further aspect the proposed method requires fewer processing steps than that required in the prior art.

These and other objects and advantages of the invention will become more fully apparent from the following description made in connection with the accompanying drawing.

Fig. 1

is a simplified cross-sectional diagram showing a portion of a semiconductor substrate having a prior art multilayer wiring structure constructed thereon.

Fig. 2

is a simplified cross-sectional diagram showing a portion of a semiconductor substrate having a prior art stud-down wiring structure constructed thereon.

Fig. 3

is a simplified cross-sectional diagram showing a portion of a semiconductor substrate having a prior art stud-up wiring structure constructed thereon.

Figs. 4A through 4D

are simplified perspective views showing the preferred processing steps of the present invention, resulting in the construction of exemplary multi-level wiring structures.

Fig. 5

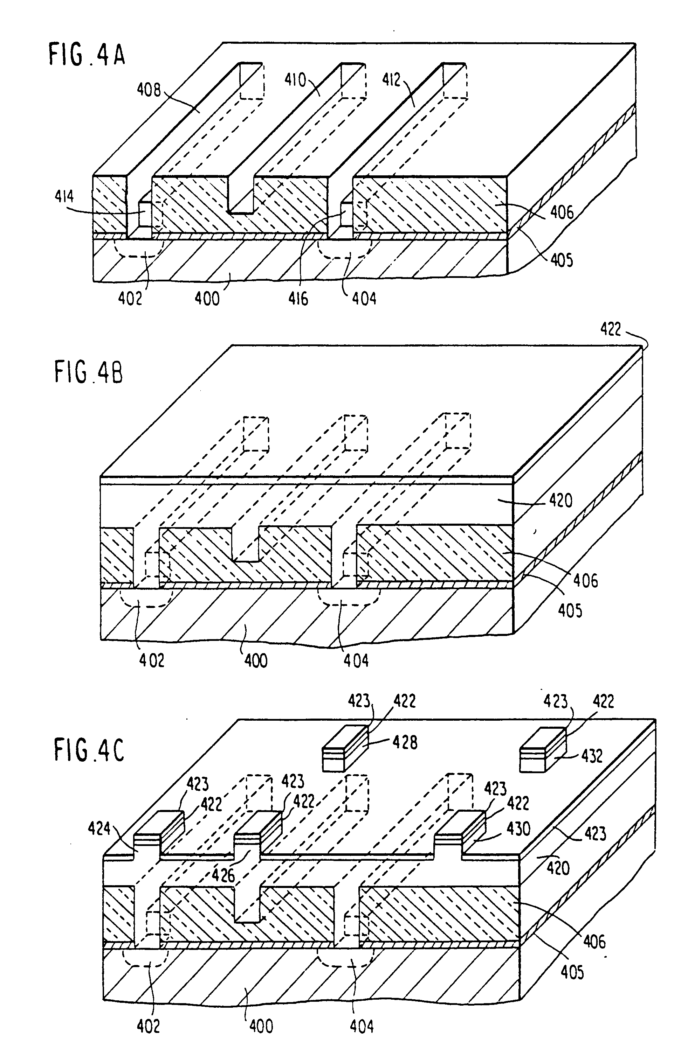

is a simplified diagram showing the exemplary wiring structures produced by the processing steps of Figs. 4A through 4D.

First, it should be understood that the height, width and thickness dimensions shown in the drawing are for the sake of example and clarity only, and are not intended to designate actual or relative dimensions, i.e. some dimensions may be exaggerated to improve the clarity of the illustrations. When known, typical dimensions will be revealed through the textual description.

Fig. 4A shows the first processing step of the wiring structure approach of the present invention. A semiconductor substrate 400 has formed therein semiconductor circuit areas 402 and 404. A barrier layer 405 is then formed on top of the semiconductor substrate surface. The purpose of the barrier layer 405 is to prevent undesirable ions from diffusing into, and contaminating, the semiconductor substrate during the high temperature processing steps to follow. In this regard, any material having protective properties can be used, as long as a sufficient thickness is deposited to provide the necessary protection. In a preferred embodiment, the barrier layer 405 is composed of silicon nitride and is deposited to a thickness of several hundred angstroms.

An insulating layer 406 then is formed on top of the semiconductor substrate 400. This insulating layer 406 can be constructed of any insulating material, for example, silicon dioxide. In a preferred embodiment, this silicon dioxide layer would be slightly doped with boron or phosphorous which facilitates the use of a subsequent high temperature treatment process to improve the planarity of the insulating layer 406. By way of example, this layer would have a typical thickness of several thousand angstroms. An alternative process for improving the planarity would be a mechanical polishing process.

Once planarized, the insulating layer 406 is masked and etched to form the wiring troughs 408, 410 and 412. Any well known semiconductor etching process can be used; for example, a preferred processing embodiment uses RIE etching with a fluorinated gas. The insulating layer 406 is then again masked and etched to form the stud-down vias 414 and 416 in the wiring troughs 408 and 412, respectively. As was previously described with reference to Fig. 1, the technique of masking and etching to form stud-down vias in the lower portion of a wiring through is well known in the art. As will become more apparent in the description to follow, the stud-down vias 414 and 416 serve to facilitate wiring line structure connection to the semiconductor diffusion areas 402 and 404, respectively.

Once the wiring troughs 408, 410 and 412, and the stud-down vias 414 and 416 have been formed, a conductive material deposit is applied to the top surface of the insulating layer 406 to fill the stud-down vias 414 and 416 and the wiring troughs 408, 410 and 412, and to form a layer 420 of conductive material on top of the insulating layer 406. Any conductive material can be used; however, the preferred material is a metal. Preferred metals include tungsten, tungsten alloys and tungsten. To deposit the conductive material layer, any of the well known deposition processes can be used, for example, chemical-vapor-deposition (CVD), evaporation and sputtering. Chemical-vapor-deposition of aluminum is preferred, as this combination produces the best results in filling the wiring troughs and stud-down vias. Also, the conductive material should be deposited in a conformal manner such that planarity of the layer 420 is maintained. The result is shown in Fig. 4B.

As to the thickness of the conductive material layer 420, it will become apparent from the following description that the layer should be of sufficient thickness to facilitate the construction of the desired wiring line structures. This thickness is dependent on a number of factors, for example, the number of wiring levels needed, the resistivity of the conductive material used, the resistive and capacitive constraints on the wiring line structures, and packaging constraints. Experimentation can be used to determine the exact thickness required. In one example, the conductive material layer is deposited to a thickness of 1,5 μm.

The material filling the stud-down vias 414 and 416 and the wiring troughs 408, 410 and 412, and the conductive material layer 420 are formed from a single homogeneous body of conductive material, since they are formed during a single deposition of conductive material. Thus, the conductive material layer 420 represents a layer having no internal metallic interfaces.

Once sufficient depositing has been made to achieve a conductive material layer of a desired thickness, a mask material 422 is applied to the top surface of the conductive material layer 420. A first resist mask and exposure (not shown) are then applied to cause the mask material 422 to remain in areas where stud-up structures are to be formed on the desired wiring structure. The conductive material layer 420 is then etched to provide the stud-up structures 424, 426, 428, 430 and 432 as shown in Fig. 4C. In this and subsequent etching of the conductive material layer 420, any of the well known semiconductor etching processes can again be used. In a preferred embodiment, reactive-ion-etching would be used. Note that the conductive material layer 420 has been etched only a portion of the way through its thickness.

Once the stud-up structures 424, 426, 428, 430 and 432 have been defined by the etching process, a second mask layer 423 is formed and masked to define desired wiring line structures. Note that in this step, the previous mask material 422 which was used to provide the resist portions for the stud-up structures may be removed or, alternatively, the second mask material 423 may be formed over the first mask material 422. As a further etching process is to be applied to form the desired wiring line structures, the first mask material 422 is maintained in a preferred embodiment to avoid alignment problems in having to reform mask material on top of the desired stud-up structures. Thus, the second mask material 423 is shown formed over the remaining portions of the first mask material 422 Fig. 4C.

Once the second mask material 423 has been masked to define the desired wiring line structures, the remaining thickness of the conductive material layer 420 is subjected to a second etching process. Etching is stopped at the top level of the insulating layer 406 such that conductive material lying within the stud-down vias and the wiring troughs is allowed to remain.

Note that in the resultant structure of Fig. 4D there is shown only the first mask material 422 remaining on top of the desired stud-up structures. Although the second mask material 423 had also been formed over these portions, these portions were left unmasked and were subsequently removed by the second etching process. In contrast, portions of the second mask material 423 are shown remaining at areas where wiring line structures were desired.

Once etching has been conducted to the top of the insulating layer 406, the remaining portions of the first mask material 422 and second mask material 423 can be removed or left in place. In a preferred embodiment, mask material portions on top of desired stud-up structures are removed to facilitate clean electrical contact.

After the processing steps described above, additional insulating material can be deposited on top of the insulating layer 406 and planarized to be level with the top of the desired stud-up structures. This serves to provide additional stability and integrity to the resultant wiring structure, as well as insulating protection to the encased wiring line structures. In a preferred embodiment, this additional insulating material is silicon dioxide.

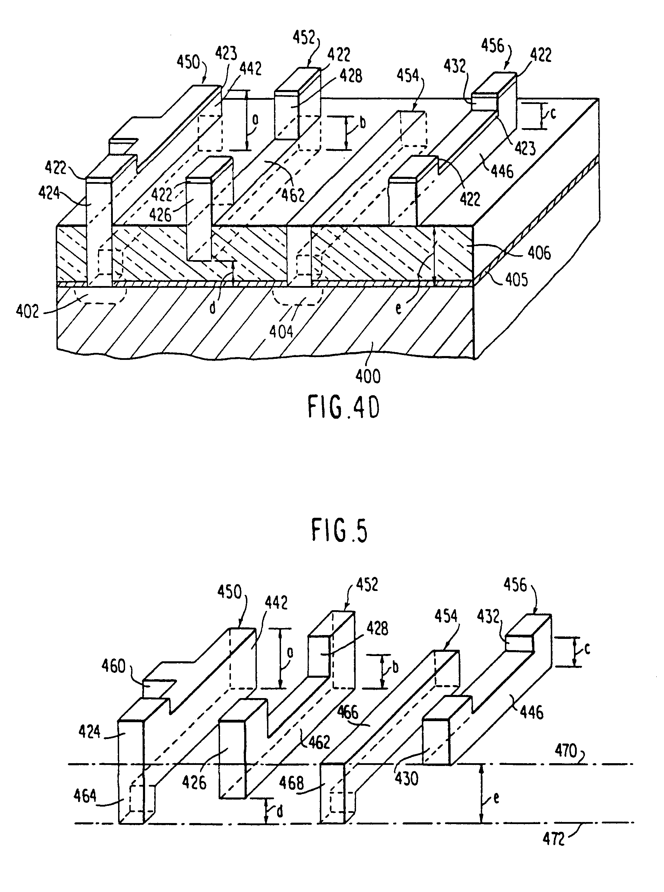

The wiring structures produced by the preferred processing steps of Figs. 4A through 4D were chosen as examples to illustrate desirable features of the present invention, as well as the versatility of the present invention. Formation of the additional insulating layer described above has not been shown. Instead, the exemplary wiring structures resulting from the processing steps of Figs. 4A through 4D are shown in Fig. 5 as having been removed from the insulating layer 406.

Turning now to a detailed description, there are shown four exemplary wiring structures 450, 452, 454 and 456 as having been formed. In a first exemplary structure, the wiring structure 450 in Fig. 4D and Fig. 5 has a stud-up structure 424, a stud-down structure 464, and a thick wiring line structure 442. In addition, the wiring structure 450 has a thin lateral wiring line structure 460. Note that the entire structure of the wiring structure 450, including the stud-up structure 424, the stud-down structure 464, the thick wiring line structure 442 and the lateral wiring line structure 460, has been formed from the same layer of conductive material. Thus, the wiring structure 450 is a homogeneous conductive material structure, which in a preferred embodiment, is formed of a metal. Thus, there is provided an electrical conduction path, from the stud-down structure 464 to the stud-up structure 424, which has no internal metallic interfaces and therefore, internal contact resistance.

The stud-down structure 464 is produced by conductive material which filled the stud-down via 414 described with reference to Fig. 4A. Similarly, the lower portion of the thick wiring line structure 442 is produced by conductive material which filled the wiring trough 408 described with reference to Fig. 4A. The upper portion of the thick wiring line structure 442 and also the thin lateral wiring line structure 460 are formed by the masking and etching of the conductive material layer 420 in accordance with the second mask material 423, as was described with reference to Fig. 4D. Finally, the stud-up structure 424 is formed by the masking and etching of the conductive material layer 420 in accordance with the first mask material 422, as was described with reference to Fig. 4C.

The thick wiring line structure 442 is thick in the sense that its thickness includes a substantial portion of the thickness between the stud-up and stud-down structures. In contrast, as will be described below, the remaining wiring line structures in the example include a much smaller portion of this thickness (e.g., one-half the thickness). As the thick wiring line structure 442 has a greater cross-sectional area along its length in comparison to the remaining lines, the thick wiring line structure 442 represents a line of lower resistance. Thus, in addition to providing a method of forming thick low resistance lines, the present invention also provides a mechanism whereby the resistance value of these thick lines can be controlled without increasing wiring pitch.

In this regard, note that the thick wiring line structure 442 is indicated in Figs. 4D and 5 as having a thickness "a", which represents the depth of the wiring trough 408 plus a thickness portion of the conductive material layer 420. As the thickness of this thick wiring line structure 442 can easily be controlled, either by controlling the depth of the wiring trough 408 or by controlling the thickness of the conductive material layer 420 used above the wiring trough 408, the resistance of the line 442 can also be controlled.

Let us now turn to a more detailed description of the second exemplary structure. The wiring structure 452 is shown having been formed with both stud-up structures 426 and 428 and also a thin wiring line structure 462. In particular, the stud-up structures 426 and 428 were formed by the etching of the conductive material layer 420 in accordance with the first mask material 422 as was described with reference to Figs. 4B and 4C. The thin wiring line structure 462 is formed by conductive material which filled the wiring trough 410 as was described with reference to Fig. 4A. The second wiring structure 452 also represents a homogeneous conductive material body formed from a single layer which, in a preferred embodiment, is a metal.

The thin wiring line structure 462 is thin in the sense that its thickness includes only a smaller portion of the thickness lying between the stud-down and stud-up structures (e.g., typically one-half the thickness). Note that the wiring line structure 462 is indicated in Fig. 4D as having a thickness "b" which exactly corresponds to the depth of the wiring trough 410 as was described with reference to Fig. 4A.

The wiring structure features of the second wiring structure 452 are advantageous in several respects. First, note that the wiring structure 452 is an underpass wiring structure having no internal metallic interfaces allowing the connection of two stud-up structures 426 and 428. The thin wiring line structure 462, which serves to connect the stud-up structures 426 and 428, is insulated from the semiconductor substrate 400 by the portion of the insulating layer 406 lying below the wiring line structure 462. The wiring line structure 462 would be further insulated from above if additional insulating material were formed above the top of the insulating layer 406, as was previously mentioned.

Another advantage of the second wiring structure 452 concerns capacitive effects. Often, in semiconductor devices, there can be a substantial capacitive effect between adjacent wiring line structures. An important feature of the wiring structure 452 is that the thin wiring line structure 462 is a line which serves to reduce this capacitive effect. If the wiring line structure 462 had been constructed as a thick wiring line structure, there would be a substantial capacitive effect between the wiring structures 450 and 452, because the wiring line structures 442 and 462 would act as the parallel plates of a capacitor. As the "parallel plate" area is substantially decreased through the use of the thin wiring line structure, the capacitive effect is also decreased.

Although the thin wiring line structure is a low capacitance line, the smaller cross-sectional area along its length, in comparison to the thick wiring line structure, means that this is a line of greater resistance. Thus, the present invention provides the versatility of constructing a thin low capacitance wiring line structure, with the trade off of increased line resistance.

Let us now turn to a detailed description of the third exemplary structure. The wiring structure 454 is similarly of a thin, low capacitance nature. More particularly, the wiring structure 454 is constructed of a thin wiring line structure 466 and a stud-down structure 468. The stud-down structure 468 is formed from conductive material which filled the stud-down via 416 described with reference to Fig. 4A and 4B. The thin wiring line structure 466 is formed from conductive material which filled the wiring trough 412, as was described with reference to Figs. 4A and 4B. Although the third wiring structure 454 is a thin low capacitance structure similar to that of the second wiring structure 452, note that the third wiring structure 454 provides an underlying circuit interconnection to a semiconductor diffusion area 404. This is in contrast to the underlying circuit interconnection between two stud-up structures as was the case of the second wiring structure 452.

In addition to a capacitive effect between adjacent wiring line structures, a capacitive effect may also occur between a wiring line structure and the semiconductor substrate body 400. As an example, the thin wiring line structures 462 and 466 could act as first parallel capacitor plates separated from the second semiconductor substrate plate 400 by a distance "d". This distance "d", indicated in Figs. 4D and 5, corresponds to the portion of the insulating layer 406 underlying and insulating the thin wiring line structures 462 and 466 from the semiconductor substrate 400. One method of reducing the capacitive effect between the thin wiring lines and the semiconductor substrate 400 is to increase the separation distance d. This increased separation from the semiconductor substrate 400 is achieved by the fourth wiring structure 456.

To illustrate this increased separation distance, a dashed line 470 has been added in Fig. 5 to represent the top of the insulating layer 406, and a dashed line 472 has been added to represent the top of the semiconductor substrate body 400.

In the second and third wiring structures 452 and 454, respectively, the thin wiring line structures 462 and 466 are formed from conductive material which filled the wiring troughs 410 and 412, respectively. In contrast, the thin wiring line structure 446 of the fourth wiring structure 456 is formed from a portion of the conductive material layer 420 lying above the top surface of the insulating layer 470.

In the example illustrated, the fourth wiring structure 456 represents a wiring structure which further reduces capacitive effects in several respects. First, capacitive effects between adjacent thin wiring line structures 466 and 446 are further reduced because the lines are offset relative to each other, as opposed to the lines 462 and 466 which are in the same plane. Next, note that since the thin wiring line structure 446 is formed from conductive material lying on top of the insulating layer 406 rather than from conductive material filling a wiring trough, the separation distance "e" from the semiconductor substrate 400 has been increased over the previous separation distance d. This increased separation from the semiconductor substrate 400 results in a decreased capacitive effect between the thin wiring line structure 446 and the semiconductor substrate 400.

In the preferred embodiment described above, there has been disclosed a unique processing approach which facilitates the construction of multi-level wiring structures formed from a homogeneous body of conductive material. More particularly, the construction approach of the present invention achieves the construction of multi-level wiring structures having no internal metallic interfaces and therefore, internal contact resistance. In addition to the above advantage, the approach of the present invention also provides the versatility of constructing stud-up, stud-down, and thick and thin wiring line structures. The thick wiring line structures are low resistance lines, and the thin wiring line structures are low capacitance lines. Finally, the separation distance of thin low capacitance lines from the semiconductor substrate can be controlled further to reduce capacitive effects between the thin wiring line structures and the semiconductor substrate.

## Claims

1. A metallization structure being a homogeneous conductive material structure on an insulation layer on a processed semiconductor substrate, comprising:

at least one stud-down; a plurality of wiring lines, at least one of said plurality of wiring lines having a first thickness and at least another one of said plurality of wiring lines having a second thickness greater than said first thickness;

and at least one stud-up, said wiring lines being aligned with and electrically connecting said stud-ups or stud-downs, at least one wiring line electrically connecting at least one of said stud-ups and at least one of said stud downs, the metallization structure thus providing an electrical conduction path, from at least one of said stud-downs to at least one of said stud-ups, which has no internal metallic interface, said stud-down, said plurality of wiring lines and said stud-up being formed from a single layer of conductive metal.

2. A method of forming a multi-level wiring structure which comprises:

a stud-up structure;
a stud-down structure; and
a wiring line structure having a lower wiring line portion;

said multi-level wiring structure being formed on a processed semiconductor substrate, wherein said method comprises the following steps:

forming an insulating layer on said processed semiconductor substrate;

masking and etching said insulating layer to define a wiring trough which is to be filled with conductive material to form said lower wiring line portion;

masking and etching said insulating layer to define a stud-down via;

depositing a layer of conductive material to fill said wiring trough and said stud-down via, and to form a coating of conductive material of a predetermined thickness on top of said insulating layer;

masking and etching said coating of conductive material to form at least one stud-up structure;

wherein said multi-level wiring structure is formed from the same deposit of conductive material.

3. The method of claim 2, wherein a plurality of wiring lines is formed as a plurality of thick and thin wiring lines, said thick wiring lines being defined by the conductive material within a wiring trough and some of the conductive material above the trough, said thin wiring lines being defined by either the conductive material solely within a wiring trough or a thickness of said conductive material not lying above a wiring trough.

4. The method of claim 2, wherein said multi-level wiring structure comprises a thick wiring line structure having an upper wiring line portion and a lower wiring line portion, and wherein said method comprises the following step:

masking and etching said coating of conductive material to define said upper wiring line portion.

**Revendications**

1. Structure de métallisation constituée d'une structure de matière conductrice homogène sur une couche isolante sur un substrat semiconducteur traité, comprenant : au moins un plot rentrant ; une pluralité de lignes de câblage, au moins une de ladite pluralité de lignes de câblage ayant une première épaisseur et au moins une autre de ladite pluralité de lignes de câblage ayant une deuxième épaisseur supérieure à ladite première épaisseur ; et au moins un plot saillant, lesdites lignes de câblage étant alignées avec lesdits plots saillants ou lesdits plots rentrants et connectant électriquement ces derniers, au moins une ligne de câblage connectant électriquement au moins un desdits plots saillants et au moins un desdits plots rentrants, la structure de métallisation constituant ainsi un chemin de conduction électrique, entre au moins un desdits plots rentrants et au moins un desdits plots saillants, qui ne comporte pas d'interface métallique interne, ledit plot rentrant, la dite pluralité de lignes de câblage et ledit plot saillant étant formés à partir d'une seule couche de métal.

2. Méthode de fabrication d'une structure de câblage à plusieurs niveaux qui comprend :

une structure de plot saillant ;

une structure de plot rentrant ; et

une structure de ligne de câblage comportant une partie de ligne de câblage inférieure ;

ladite structure de câblage à plusieurs niveaux étant formée sur un substrat semiconducteur traité, ladite méthode comprenant les étapes suivantes :

formation d'une couche isolante sur ledit substrat semiconducteur traité ;

masquage et attaque de ladite couche isolante de manière à définir une gorge de câblage qui doit être remplie de matière conductrice pour former ladite partie de ligne de câblage inférieure ;

masquage et attaque de ladite couche isolante pour définir une traversée de plot rentrant ;

dépôt d'une couche de matière conductrice pour remplir ladite gorge de câblage et ladite traversée de plot rentrant, et pour former un revêtement de matière conductrice d'épaisseur prédéterminée sur le dessus de ladite couche isolante ; et

masquage et attaque dudit revêtement de matière conductrice pour former au moins une structure de plot saillant ;

de sorte que ladite structure de câblage à plusieurs niveaux est formée à partir du même dépôt de matière conductrice.

3. Méthode suivant la revendication 2, dans laquelle une pluralité de lignes de câblage est sous la forme d'une pluralité de lignes de câblage épaisses et minces, lesdites lignes de câblage épaisses étant définies par la matière conductrice dans une gorge de câblage et une certaine quantité de la matière conductrice au-dessus de la gorge, lesdites lignes de câblage minces étant définies par la matière conductrice seulement dans une gorge de câblage ou par une épaisseur de ladite matière conductrice ne se trouvant pas au-dessus d'une gorge de câblage.

4. Méthode suivant la revendication 2, dans laquelle ladite structure de câblage à plusieurs niveaux comprend une structure de ligne de câblage épaisse comportant une partie de ligne de câblage supérieure et une partie de ligne de câblage inférieure, et ladite méthode comprenant les opérations de masquage et d'attaque dudit revêtement de matière conductrice pour définir ladite partie de ligne de câblage supérieure.

**Patentansprüche**

1. Metallisierungsstruktur, die eine homogene Struktur aus leitendem Material auf einer Isolierschicht eines prozessierten Halbleitersubstrates ist, bestehend aus:
zumindest einem sich nach unten erstreckenden Zapfen, einer Vielzahl von Verdrahtungsleitungen, von denen zumindest eine eine erste Dicke aufweist und zumindest eine andere aus der Vielzahl von Verdrahtungsleitungen eine zweite Dicke aufweist, die größer als die erste Dicke ist, und zumindest einem sich nach oben erstreckenden Zapfen, wobei die Verdrahtungsleitungen mit den sich nach oben oder unten erstreckenden Zapfen ausgerichtet sind und sie elektrisch verbinden, wobei zumindest eine Verdrahtungsleitung elektrisch zumindest einen der sich nach oben erstreckenden Zapfen verbindet und zumindest einen der sich nach unten erstreckenden Zapfen, wobei die Metallisierungsstruktur so einen elektrischen Leitungspfad von zumindest einem der sich nach unten erstreckenden Zapfen zu zumindest einem der sich nach oben erstreckenden Zapfen schafft, der keine interne metallische Zwischenebene aufweist, wobei der sich nach unten erstreckende Zapfen, die Vielzahl von Verdrahtungsleitungen und der sich nach oben erstreckende Zapfen aus einer einzigen Metallisierungsschicht gebildet werden.

2. Verfahren zum Bilden einer mehrschichtigen Verdrahtungsstruktur, die besteht aus:
einer Struktur von sich nach oben erstreckenden Zapfen,
einer Struktur von sich nach unten erstreckenden Zapfen, und
einer Struktur von Verdrahtungsleitungen, die einen Teil mit unteren Verdrahtungsleitungen aufweist,
wobei die mehrschichtige Verdrahtungsstruktur auf einem prozessierten Halbleitersubstrat gebildet wird, und das Verfahren die folgenden Schritte umfaßt:
Bilden einer Isolierschicht auf dem prozessierten Halbleitersubstrat,
Maskieren und Ätzen der Isolierschicht, um eine Verdrahtungsrinne zu definieren, die mit leitendem Material zu füllen ist, um den unteren Teil der Verdrahtungsleitungen zu bilden,
Maskieren und Ätzen der Isolierschicht, um eine sich nach unten erstreckende Durchverbindung zu definieren,
Abscheiden einer Schicht von leitendem Material, um die Verdrahtungsrinne und die sich nach unten erstreckende Durchverbindung zu füllen und um eine Beschichtung aus leitendem Material einer vorgegebenen Dicke auf der Isolierschicht zu bilden,
Maskieren und Ätzen der Beschichtung aus leitendem Material, um zumindest eine Struktur von sich nach unten erstreckenden Zapfen zu bilden,
wodurch die mehrschichtige Verdrahtungsstruktur aus der gleichen Abscheidung von leitendem Material gebildet wird.

3. Verfahren nach Anspruch 2, bei dem eine Vielzahl von Verdrahtungsleitungen als eine Vielzahl von dicken und dünnen Verdrahtungsleitungen gebildet wird, wobei die dicken Verdrahtungsleitungen durch das leitende Material in einer Verdrahtungsrinne und etwas von dem leitenden Material über der Rinne und die dünnen Verdrahtungsleitungen entweder nur durch das leitende Material innerhalb einer Verdrahtungsrinne oder durch eine Dicke des leitenden Materials, die nicht über der der Verdrahtungsrinne liegt, gebildet werden.

4. Verfahren nach Anspruch 2, bei dem die mehrschichtige Verdrahtungsstruktur aus einer Struktur von dicken Verdrahtungsleitungen besteht, die einen oberen Teil an Verdrahtungsleitungen und einen unteren Teil an Verdrahtungsleitungen aufweist, und bei der das Verfahren den folgenden Schritt umfaßt:
Maskieren und Ätzen der Beschichtung aus leitenden Material, um den oberen Teil der Verdrahtungsleitungen zu definieren.

FIG.1 PRIOR ART

FIG.2 PRIOR ART

FIG.3 PRIOR ART

FIG.4A

408    410    412

414

406

405

402    400    416    404

FIG.4B

422

420

406

405

402    400    404

FIG.4C

423  422
428

423  422
432

423  422

424

423  422

423

430

423

420

426

406

405

402    400    404

FIG.4D

FIG.5